(19) Europäisches Patentamt
European Patent Office
Office européen des brevets

(11) **EP 2 544 247 B1**

(12) **EUROPÄISCHE PATENTSCHRIFT**

(45) Veröffentlichungstag und Bekanntmachung des Hinweises auf die Patenterteilung:
**25.06.2014 Patentblatt 2014/26**

(21) Anmeldenummer: **12175718.1**

(22) Anmeldetag: **19.11.2001**

(51) Int Cl.:
*H01L 33/00* *(2010.01)*    *H01L 33/50* *(2010.01)*
*G02B 6/00* *(2006.01)*    *C09K 11/77* *(2006.01)*
*B82Y 20/00* *(2011.01)*

(54) **Lichtquelle mit einem lichtemittierenden Element**

Light source with a light-emitting element

Source lumineuse dotée d'un élément émettant de la lumière

(84) Benannte Vertragsstaaten:
**AT BE CH CY DE DK ES FI FR GB GR IE IT LI LU MC NL PT SE TR**

(30) Priorität: **28.12.2000 AT 21542000**

(43) Veröffentlichungstag der Anmeldung:
**09.01.2013 Patentblatt 2013/02**

(62) Dokumentnummer(n) der früheren Anmeldung(en) nach Art. 76 EPÜ:
**08164012.0 / 2 006 924**
**01272551.1 / 1 352 431**

(73) Patentinhaber:
• **Tridonic Jennersdorf GmbH**
  **8380 Jennersdorf (AT)**
• **Litec GBR**
  **17489 Greifswald (DE)**
• **Leuchtstoffwerk Breitungen GmbH**
  **98597 Breitungen (DE)**
• **Toyoda Gosei Co., Ltd.**
  **Aichi 492-8564 (JP)**

(72) Erfinder:
• **Tasch, Stefan**
  **8380 Jennersdorf (AT)**
• **Pachler, Peter**
  **8042 Graz (AT)**
• **Roth, Gundula**
  **17498 Levenhagen (DE)**
• **Tews, Walter**
  **17489 Greifswald (DE)**
• **Kempfert, Wolfgang**
  **36448 Bad Liebenstein (DE)**
• **Starick, Detlef**
  **17491 Greifswald (DE)**

(74) Vertreter: **Rupp, Christian**
**Mitscherlich PartmbB**
**Patent- und Rechtsanwälte**
**Sonnenstraße 33**
**80331 München (DE)**

(56) Entgegenhaltungen:
EP-A2- 0 854 523    WO-A1-00/33390
WO-A1-01/24283    WO-A1-97/50132
WO-A1-99/50916    GB-A- 2 347 018
JP-A- 2000 031 532

EP 2 544 247 B1

**Beschreibung**

TECHNISCHES GEBIET

Die vorliegende Erfindung betrifft eine Lichtquelle mit einem Licht emittierenden Element, das in einem ersten Spektralbereich, vorzugsweise im blauen und/oder ultravioletten Bereich des optischen Spektrums, emittiert, und mit einem Luminophor. Der ausgewählte Luminophor kann auch in Mischungen mit anderen Luminophoren dieser Gruppe und/oder mit weiteren Leuchtstoffen, die nicht zu dieser Gruppe gehören, eingesetzt werden.

Das Licht emittierende Element ist vorzugsweise eine anorganische LED, es kann aber auch eine organische LED, eine Laserdiode, eine anorganische Dickschichtelektrolumineszenzfolie oder ein anorganisches Dünnschichtelektrolumineszenzbauelement sein.

STAND DER TECHNIK

Anorganische LEDs zeichnen sich unter anderem durch hohe Lebensdauer, geringen Platzbedarf, Erschütterungsunempfindlichkeit und spektral engbandige Emission aus.

Zahlreiche Emissionsfarben - speziell spektral breitbandige - können mittels der intrinsischen Emission eines aktiven Halbleitermaterials in LEDs nicht oder nur ineffizient realisiert werden. Vor allem trifft dies auf die Erzeugung von weißem Licht zu.

Gemäß dem Stand der Technik werden Emissionsfarben, welche mit dem Halbleiter intrinsisch nicht realisiert werden können, mittels Farbkonversion erzeugt.

Im Wesentlichen basiert die Technik der Farbkonversion auf dem Prinzip, dass zumindest ein Luminophor über dem LED-Die angeordnet wird. Dieser absorbiert einen Teil der vom Die emittierten Strahlung und wird dabei zur Photolumineszenz angeregt. Die Emissions- bzw. Lichtfarbe der Quelle ergibt sich dann aus der Mischung der transmittierten Strahlung des Die und der emittierten Strahlung des Leuchtstoffes.

Als Luminophore können grundsätzlich sowohl organische als auch' anorganische Systeme eingesetzt werden. Der wesentliche Vorteil anorganischer Pigmente liegt in der höheren chemischen, Temperatur- und Strahlungsstabilität im Vergleich zu organischen Systemen. Im Zusammenhang mit der hohen Lebensdauer der anorganischen LEDs sichern langlebige anorganische Luminophore eine hohe Farbortstabilität der aus beiden Komponenten bestehenden Lichtquelle.

Soll die von blau emittierenden LEDs ausgesendete Strahlung in weißes Licht konvertiert werden, werden Leuchtstoffe benötigt, die das blaue Licht (450-490 nm) wirkungsvoll absorbieren und mit hoher Effizienz in größtenteils gelbe Lumineszenzstrahlung umwandeln. Allerdings gibt es nur eine geringe Anzahl anorganischer Luminophore, die diese Anforderungen erfüllen. Derzeit werden zumeist Materialien aus der YAG-Leuchtstoffklasse als Farbkonversionspigmente für blaue LEDs eingesetzt (WO 98/05078; WO 98/05078; WO 98/12757). Diese weisen allerdings den Nachteil auf, dass sie nur bei einem Emissionsmaximum kleiner als 560 nm eine genügend hohe Effizienz besitzen. Aus diesem Grund können mit den YAG-Pigmenten in Kombination mit blauen Dioden (450-490nm) nur kalt-weiße Lichtfarben mit Farbtemperaturen zwischen 6000 und 8000 K und mit vergleichsweise niedriger Farbwiedergabe (typische Werte für den Farbwiedergabeindex Ra liegen zwischen 70 und 75) realisiert werden. Daraus ergeben sich stark eingeschränkte Anwendungsmöglichkeiten. Zum einen werden bei der Anwendung von Weißlichtquellen in der Allgemeinbeleuchtung in der Regel höhere Anforderungen an die Farbwiedergabequalität der Leuchtmittel gestellt, und zum anderen werden von den Konsumenten vor allem in Europa und in Nordamerika wärmere Lichtfarben mit Farbtemperaturen zwischen 2700 und 5000 K bevorzugt.

Aus der WO 00/33389 ist weiterhin bekannt, u.a. $Ba_2SiO_4$:$Eu^{2+}$ als Luminophor zur Konvertierung des Lichtes blauer LEDs zu verwenden. Das Maximum der Emission des Leuchtstoffes $Ba_2SiO_4$:$Eu^{2+}$ liegt aber bei 505 nm, so dass mit einer solchen Kombination mit Sicherheit kein weißes Licht erzeugt werden kann.

In der Arbeit von S.H.M. Poort et al: "Optical properties of Eu2+-activated orthosilicates and orthophospates", Journal of Alloys and Compounds 260 (1997), S 93-97 werden die Eigenschaften von Eu-aktiviertem $Ba_2SiO_4$ sowie von Phosphaten wie $KBaPO_4$ und $KSrPO_4$ untersucht. Auch hier wird festgestellt, dass die Emission von $Ba_2SiO_4$ bei etwa 505 nm liegt.

WO 97/50132 offenbart eine Lichtquelle mit einem LED-Chip, der auf einer Leiterplatte innerhalb einer Ausnehmung eines Grundgehäuses angeordnet ist. Die Ausnehmung ist hinsichtlich ihrer Form als Reflektor für die von dem LED-Chip im Betrieb ausgesandte Strahlung ausgebildet. Über dem Reflektor ist eine Lichtscheibe mit einem Luminophor angeordnet, da die Ausnehmung von einer Lumineszenzkonversionsschicht, beispielsweise eine separat hergestellte und auf dem Grundgehäuse befestigte Abdeckplatte, abgedeckt ist. Der LED-Chip ist mit Einkapselmittel vergossen, da die Ausnehmung mit einem transparenten Kunststoff oder einem anorganischen Glas gefüllt sein kann. WO 97/50132 lehrt auch eine Mehrzahl von spektral selektiv emittierenden Lumineszenzkonversionselementen relativ zum LED-Chip hintereinander anzuordnen.

OFFENBARUNG DER ERFINDUNG

Es ist Aufgabe der vorliegenden Erfindung, eine Lichtquelle der eingangs genannten Art so abzuändern, dass mit ihr bei gleichzeitig hoher Lichtausbeute und hoher Farbwiedergabequalität Weißlichtfarben mit wärmeren Farbtemperaturen erzeugt werden können, insbesondere diejenigen Farborte, die innerhalb der von der CIE für die Allgemeinbeleuchtung festgelegten Toleranzellipsen liegen.

Diese Aufgabe wird durch eine Lichtquelle der eingangs genannten Art erfindungsgemäß durch die Merkmale des Anspruchs 1 gelöst. Die abhängigen Ansprüche bilden die Erfindung vorteilhaft weiter.

Ein Verfahren zur Herstellung einer erfindungsgemäßen Lichtquelle wird in Anspruch 7 definiert.

Überraschenderweise wurde gefunden, dass weißes Licht mit guter Farbwiedergabe und hoher Lichtausbeute durch Kombination einer blauen LED mit einem Luminophor, ausgewählt aus der Gruppe der europiumaktivierten Erdalkaliorthosilikate oben genannter Zusammensetzung, realisiert werden kann. Im Gegensatz zu Luminophoren, die auf reinen Bariumorthosilikaten basieren und bläulich-grünes Licht ausstrahlen, kann nämlich durch Barium-Strontium-OrthosilikatMischkristalle gelb-grünes, gelbes bis gelb-orangefarbenes und durch Einbau von Calcium in das Orthosilikatgitter sogar vollständig orangefarbenes Lumineszenzlicht erzeugt werden, so dass dann durch Mischung des transmittierten Lichtes der blauen LED und des emittierten Lumineszenzlichtes des ausgewählten Luminophors weißes Licht hoher Farbwiedergabe und hoher Effizienz generiert werden kann. Die Verschiebung der Emissionsfarbe durch Substitution von Ba durch Sr in Orthosilikaten war bisher nur für die Anregung mit harter UV-Strahlung (254nm-Anregung) aus der oben genannten Arbeit von Poort et al. bekannt; dass dieser Effekt überraschender Weise verstärkt bei der Bestrahlung mit blauem Licht im Bereich von 440-475 nm auftritt, wurde dagegen noch nicht beschrieben. Ba-Sr-Ca-Orthosilikatmischkristalle und ihr starkes Emissionsvermögen bei Anregung mit langwelliger UV-Strahlung oder blauem Licht waren bisher gänzlich unbekannt.

Der ausgewählte Luminophor kann auch in Mischungen mit anderen Luminophoren dieser Gruppe und/oder mit zusätzlichen Leuchtstoffen, die nicht zu dieser Gruppe gehören, eingesetzt werden. Zu den letztgenannten Leuchtstoffen gehören z.B. blau emittierende Erdalkalialuminate, aktiviert mit zweiwertigem Europium und/oder Mangan, sowie die rot emittierenden Luminophore aus der Gruppe $Y(V,P,Si)O_4$ :Eu, Bi, $Y_2O_2S$:Eu,Bi oder aber europium- und manganaktivierte Erdalkali-Magnesium-disi-likate :$Eu^{2+}$,$Mn^{2+}$ der Formel

$$Me_{(3-x-y)}MgSi_2O_8{:}xEu, yMn,$$

mit

$$0{,}005 < x < 0{,}5$$

$$0{,}005 < y < 0{,}5$$

und Me = Ba und/oder Sr und/oder Ca.

Wie in den unten angeführten Ausführungsbeispielen gezeigt wird, darf der Sr-Anteil in den Misch-kristall-Luminophoren nicht zu gering sein, um weißes Licht generieren zu können.

Überraschender Weise wurde weiters gefunden, dass der zusätzliche Einbau von $P_2O_5$, $Al_2O_3$ und/oder $B_2O_3$ in das Orthosilikatgitter sowie die Substitution eines Teils des Siliciums durch Germanium ebenfalls einen beträchtlichen Einfluss auf das Emissionsspektrum des jeweiligen Luminophors haben, so dass dieses für den jeweiligen Anwendungsfall in vorteilhafter Weise weiter variiert werden kann. Dabei bewirken kleinere Ionen als Si(IV) im Allgemeinen eine Verschiebung des Emissionsmaximum in den längerwelligen Bereich, während größere Ionen den Emissionsschwerpunkt zu kürzeren Wellenlängen verschieben. Weiterhin konnte gezeigt werden, dass es für die Kristallinität, das Emissionsvermögen und insbesondere für die Stabilität der erfindungsgemäßen Luminophore vorteilhaft sein kann, wenn zusätzlich geringe Mengen einwertiger Ionen wie z.B. Halogenide und/oder Alkalimetallionen in das Luminophorgitter eingebaut werden.

Gemäß einer weiteren vorteilhaften Ausgestaltung der Erfindung weist die Lichtquelle zumindest zwei verschiedene Luminophore auf, wobei zumindest einer ein Erdalkaliorthosilikatleuchtstoff ist. Auf diese Weise lässt sich der für die jeweilige Anwendung geforderte Weißton besonders genau einstellen und es lassen sich insbesondere Ra-Werte größer 80 erreichen. Eine weitere vorteilhafte Variante der Erfindung besteht in der Kombination einer im ultravioletten Bereich des Spektrums, beispielsweise im Bereich zwischen 370 und 390 nm, emittierenden LED mit zumindest drei Leuchtstoffen, von denen zumindest einer ein Erdalkaliorthosilikatleuchtstoff ist. Als zusätzliche Leuchtstoffe können in den entsprechenden Leuchtstoffmischungen blau emittierende Erdalkalialuminate, aktiviert mit Europium und/oder Mangan und/oder rot emittierende Luminophore aus der Gruppe $Y(V,P,Si)O_4$:Eu,Bi, $Y_2O_2S$:Eu,Bi oder aber aus der Gruppe der europium- und manganaktivierten Erdalkali-Magnesiumdisilikate eingesetzt werden.

Für die mechanische Ausführung der erfindungsgemäßen Lichtquelle gibt es mehrere Möglichkeiten. Gemäß der Erfindung ist vorgesehen, dass ein oder mehrere LED-Chips auf einer Leiterplatte innerhalb eines Reflektors angeordnet sind und der Luminophor in einer Lichtscheibe, die über dem Reflektor angeordnet ist, dispergiert ist.

Es ist aber auch möglich, dass ein oder mehrere LED-Chips auf einer Leiterplatte innerhalb eines Reflektors angeordnet sind und der Luminophor auf dem Reflektor aufgebracht ist.

Vorzugsweise sind die LED-Chips mit einer transparenten Vergussmasse, die kuppelartige Form besitzt, vergossen. Diese Vergussmasse bildet einerseits einen mechanischen Schutz, andererseits verbessert sie auch die optischen Eigenschaften (besserer Austritt des Lichts aus den LED-Dice).

Der Luminophor kann auch in einer Vergussmasse dispergiert sein, die eine Anordnung von LED-Chips auf einer Leiterplatte und eine Polymerlinse möglichst ohne Gaseinschlüsse verbindet, wobei die Polymerlinse und die Vergussmasse Brechungsindizes aufweisen, die sich maximal um 0,1 unterscheiden. Diese Vergussmasse kann direkt die LED-Dice einschließen, es ist aber auch möglich, dass diese mit einer transparenten Vergussmasse vergossen sind (dann gibt es also eine transparente Vergussmasse und eine Vergussmasse mit dem Luminophor). Durch die ähnlichen Brechungsindizes gibt es an den Grenzflächen kaum Verluste durch Reflexion.

Vorzugsweise weist die Polymerlinse eine kugel- bzw. ellipsoidförmige Ausnehmung auf, welche durch die Vergussmasse ausgefüllt ist, sodass das LED-Array in geringem Abstand zur Polymerlinse befestigt ist. Auf diese Weise kann die Höhe des mechanischen Aufbaus verringert werden.

Um eine gleichmäßige Verteilung des Luminophors zu erreichen, ist es zweckmäßig, wenn der Luminophor in einer vorzugsweise anorganischen Matrix aufgeschlämmt ist.

Bei Verwendung von zumindest zwei Luminophoren ist es günstig, wenn die zumindest zwei Luminophore einzeln in Matrizen dispergiert sind, die in Lichtausbreitung hintereinander angeordnet sind. Dadurch kann die Konzentration der Luminophore im Vergleich zu einer einheitlichen Dispersion der verschiedenen Luminophore reduziert werden.

Nachfolgend sind die wesentlichen Schritte zur Herstellung der Luminophore in einer bevorzugten Variante der Erfindung dargestellt:

Für die Herstellung der Erdalkaliorthosilikat-Luminophore werden entsprechend der gewählten Zusammensetzung die stöchiometrischen Mengen der Ausgangsstoffe Erdalkalicarbonat, Siliciumdioxid sowie Europiumoxid innig gemischt und in einer für die Leuchtstoffherstellung üblichen Festkörperreaktion in reduzierender Atmosphäre bei Temperaturen zwischen 1100°C und 1400°C in den gewünschten Luminophor umgewandelt. Dabei ist es für die Kristallinität von Vorteil, der Reaktionsmischung kleine Anteile, vorzugsweise kleiner als 0,2 Mol, Ammoniumchlorid oder andere Halogenide zuzugeben. Im Sinne der aufgezeigten Erfindung kann auch ein Teil des Siliciums durch Germanium, Bor, Aluminium, Phosphor ersetzt werden, was durch Zugabe entsprechender Mengen von Verbindungen der genannten Elemente, die sich thermisch in Oxide zersetzen lassen, realisiert wird. In ähnlicher Weise kann erreicht werden, dass geringe Mengen von Alkalimetallionen in das jeweilige Gitter eingebaut werden.

Die erhaltenen Orthosilikatluminophore emittieren bei Wellenlängen zwischen etwa 510 nm und 600 nm und besitzen eine Halbwertsbreite bis zu 110 nm.

Durch entsprechende Gestaltung der Reaktionsparameter und durch bestimmte Zusätze, z.B. von einwertigen Halogenid - und/oder Alkalimetallionen, kann die Korngrößenverteilung der erfindungsgemäßen Luminophore an die Anforderungen der jeweiligen Anwendung optimal angepasst werden, ohne dass schädigende mechanische Zerkleinerungsprozesse durchgeführt werden müssen. Auf diese Weise lassen sich alle schmal- und breitbandigen Korngrößenverteilungen mit mittleren Korngrößen $d_{50}$ von etwa 2 $\mu$m bis 20 $\mu$m einstellen.

Die Lichtquelle gemäß der Erfindung weist wenigstens einen LED-Chip auf, der auf einer Leiterplatte angeordnet ist, wobei der wenigstens eine LED-Chip auf der Leiterplatte innerhalb eines Reflektors angeordnet ist, wobei eine Lichtscheibe über dem Reflektor angeordnet ist, und wobei in diese Lichtscheibe ein Luminophor eingemischt ist.

Der wenigstens eine LED-Chip erzeugt vorzugsweise blaues Licht oder UV-Strahlung, welches bzw. welche durch die Lichtscheibe hindurchtritt und beim Durchgang anteilig durch den Luminophor in einen zweiten Spektralbereich konvertiert wird, so dass sich insgesamt ein weisser Farbeindruck ergibt.

Der wenigstens eine LED-Chip ist mit Einkapselmittel vergossen.

Die Einkapselmittel sind vorzugsweise kuppelartig, in der Form einer Halbkugel oder eines Halbellipsoids ausgebildet.

Die Einkapselmittel umfassen vorzugsweise jeden LED-Chip einzeln oder stellen eine gemeinsame Form für alle LED-Chips dar.

Die Lichtscheibe ist beabstandet oberhalb der Einkapselmittel angeordnet.

Die Einkapselmittel sind vorzugsweise eine Vergussmasse.

Die Lichtscheibe weist vorzugsweise opake oder streuende Eigenschaften auf.

Zumindest zwei verschiedene Luminophore werden eingesetzt.

Der erste Luminophor ist auf dem Reflektor aufgebracht und der zweite Luminophor ist in der Lichtscheibe eingebracht.

KURZE BESCHREIBUNG DER ZEICHNUNGEN

Weitere Vorteile der Erfindung werden im Folgenden anhand von Ausführungsbeispielen und Figuren erläutert.

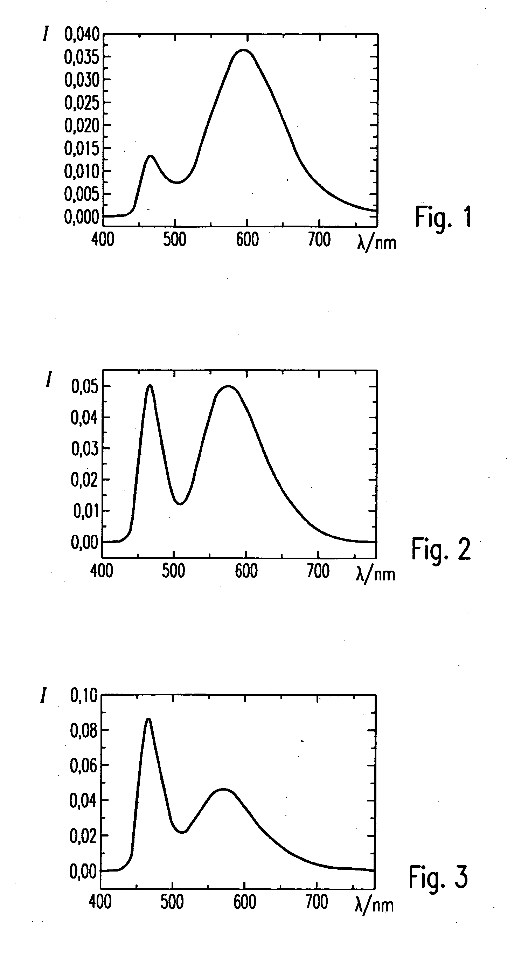

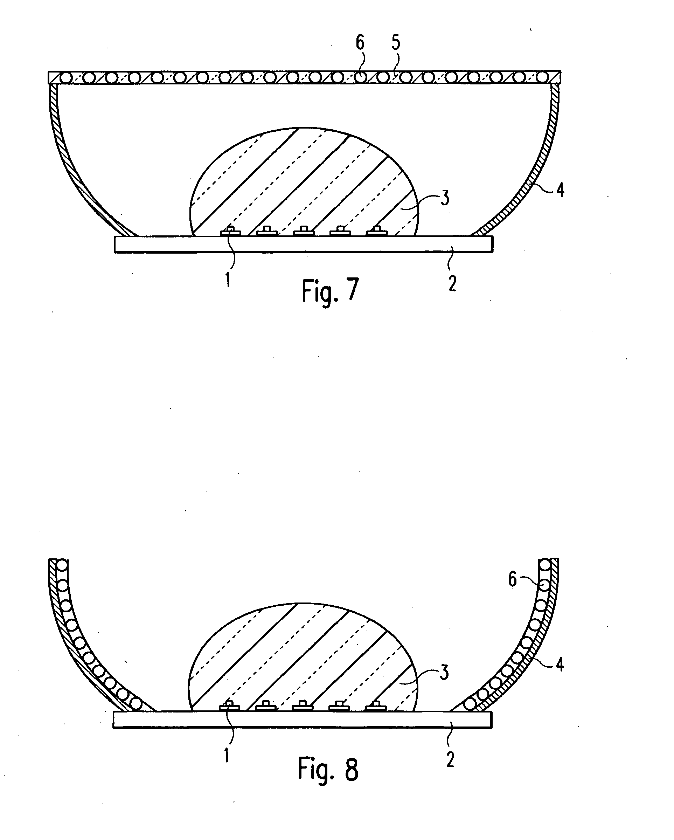

Fig. 1-6 zeigen Spektren (relative Intensität I abhängig von der Wellenlänge) verschiedener LED-Lichtquellen; und die Fig. 7-10 zeigen verschiedene Ausführungsformen erfindungsgemäßer LED-Lichtquellen.

BESTE AUSFÜHRUNGSFORMEN DER ERFINDUNG

Fig. 1 zeigt das Emissionsspektrum einer weißen LED mit einer Farbtemperatur von 2700 K, die durch Kombination einer in einem ersten Spektralbereich mit einer Schwerpunktswellenlänge von 464 nm emittierenden blauen LED und einem Luminophor der Zusammensetzung ($Sr_{1,4}Ca_{0,6}SiO_4:Eu^{2+}$), der in einem zweiten Spektralbereich mit einem Maximum von 596 nm emittiert, entstanden ist.

Weitere Beispiele für die Kombination einer bei 464 nm emittierenden LED mit jeweils einem Othosilikatluminophor sind in den Fig. 2 und 3 dargestellt. Wird ein gelb emittierender Luminophor der Zusammensetzung $Sr_{1,90}Ba_{0,08}Ca_{0,02}SiO_4:Eu^{2+}$ zur Farbkonvertierung verwendet, kann eine Weißlichtfarbe mit einer Farbtemperatur von 4100 K eingestellt werden, während bei der Verwendung des Luminophors $Sr_{1,84}Ba_{0,16}SiO_4:Eu^{2+}$ beispielsweise eine Weißlichtquelle mit einer Farbtemperatur von 6500 K gefertigt werden kann.

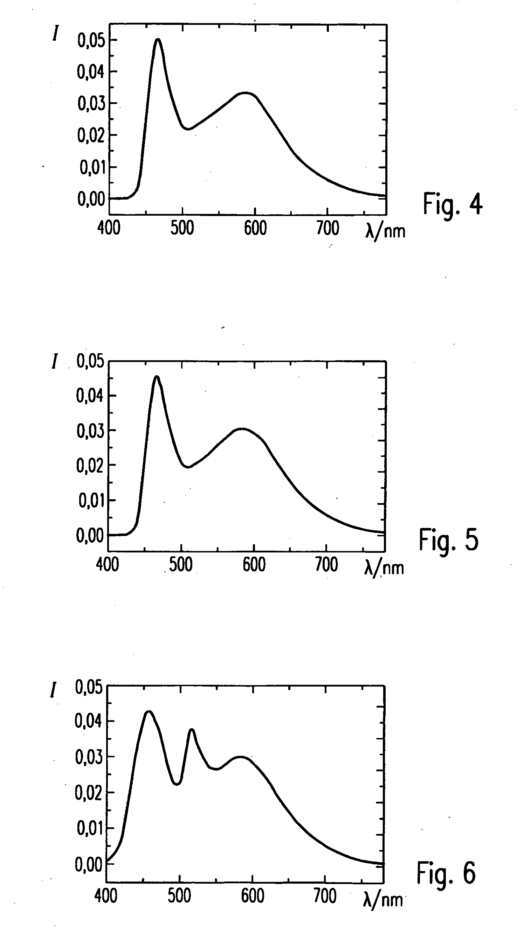

Ein typisches Spektrum für die Kombination einer 464 nm - LED mit zwei Orthosilikatluminophoren zeigt Fig. 4. Die verwendeten Leuchtstoffe weisen die Zusammensetzungen $Sr_{1,4}Ca_{0,6}SiO_4:Eu^{2+}$ und $Sr_{1,00}Ba_{1,00}SiO_4:Eu^2$ auf. Für das in der Abbildung 4 dargestellte konkrete Spektrum werden eine Farbtemperatur von 5088K und ein Farbwiedergabeindex Ra von 82 erhalten. Allerdings können in Abhängigkeit von den gewählten Mengenverhältnissen der Luminophore alle Farbtemperaturen im Bereich zwischen etwa 3500 K und 7500 K realisiert werden, wobei der große Vorteil derartiger Mischungen aus zwei erfindungsgemäßen Erdalkaliorthosilikat-Luminophoren vor allem darin besteht, dass zugleich Ra-Werte größer 80 erreicht werden können.

Das wird in der Fig. 5 beispielhaft dokumentiert. Das dargestellte Spektrum steht für die Kombination einer 464 nm - LED mit einer Mischung aus den zwei Luminophoren $Sr_{1,6}Ca_{0,4}Si_{0,98}Ga_{0,02}O_4:Eu^{2+}$ und $Sr_{1,10}Ba_{0,90}SiO_4:Eu^2$ und liefert bei einer Farbtemperatur von 5000K einen Ra-Werte von 82.

Wird als strahlungsemittierendes Element eine UV-LED verwendet, die in einem ersten Spektralbereich mit einem Maximum von 370-390nm emittiert, dann lassen sich durch Kombination einer solchen LED mit einer Leuchtstoffmischung, die die Luminophore von Fig. 4 und zugleich einen bestimmten Anteil eines blau-grün emittierenden Barium-Magnesium-Aluminatleuchtstoff:Eu,Mn enthält, Ra-Werte größer 90 realisieren. Die Fig. 6 zeigt das Emissionsspektrum einer entsprechenden Weißlichtquelle, die bei einer Farbtemperatur von 6500K einen Ra von 91 aufweist.

Weitere Bespiele sind der folgenden Aufstellung zu entnehmen. Dabei wurden neben der Emissionswellenlänge der verwendeten anorganischen LED und der jeweiligen Zusammensetzung der erfindungsgemäßen Luminophore die resultierenden Farbtemperaturen und Ra-Werte sowie die Farborte der Lichtquellen angegeben:

T = 2778 K (464 nm + $Sr_{1,4}Ca_{0,6}SiO_4:Eu^{2+}$) ; x = 0,4619, y = 0,4247, Ra = 72

T = 2950 K (464 nm + $Sr_{1,4}Ca_{0,6}SiO_4:Eu^{2+}$) ; x = 0,4380, y = 0,4004, Ra = 73

T = 3497 K (464 nm + $Sr_{1,6}Ba_{0,4}SiO_4:Eu^{2+}$) ; x = 0,4086, y = 0,3996, Ra = 74

T = 4183 K (464 nm + $Sr_{1,9}Ba_{0,08}Ca_{0,02}SiO_4:Eu^{2+}$); x = 0,3762, y = 0,3873, Ra = 75

T = 6624 K (464 nm + $Sr_{1,9}Ba_{0,02}Ca_{0,08}SiO_4:Eu^{2+}$) ; x = 0,3101, y = 0,3306, Ra = 76

T = 6385 K (464 nm + $Sr_{1,6}Ca_{0,4}SiO_4:Eu^{2+}$ + $Sr_{0,4}Ba_{1,6}SiO_4:Eu^{2+}$) ; ; x = 0,3135, y = 0,3397, Ra = 82

T = 4216 K (464 nm + $Sr_{1,9}Ba_{0,08}Ca_{0,02}SiO_4:Eu^{2+}$)) ; x = 0,3710, y = 0,3696, Ra = 82

3954 K (464 nm + $Sr_{1,6}Ba_{0,4}SiO_4:Eu^{2+}$ + $Sr_{0,4}Ba_{1,6}SiO_4:Eu^{2+}$ + $YVO_4:Eu^{3+}$); x = 0,3756, y = 0,3816, Ra = 84

T = 6489 K (UV-LED + $Sr_{1,6}Ca_{0,4}SiO_4:Eu^{2+}$ + $Sr_{0,4}Ba_{1,6}SiO_4:Eu^{2+}$ + Barium-Magnesium-Aluminat: $Eu^{2+}$) ; x = 0,3115, y = 0,3390, Ra = 86

T = 5097 K (464 nm + $Sr_{1,6}Ba_{0,4}(Si_{0,98}D_{0,02})O_4:Eu^{2+}$ + $Sr_{0,6}Ba_{1,4}SiO_4:Eu^{2+}$) ; x = 0,3423, y = 0,3485, Ra = 82

T = 5084 K (UV-LED + $Sr_{1,6}Ca_{0,4}(Si_{0,99}B_{0,01})O_4:Eu^{2+}$ + $Sr_{0,6}Ba_{1,4}SiO_4:Eu^{2+}$ +Strontium-Magnesium-Aluminat: $Eu^{2+}$) ; x = 0,3430, y = 0,3531, Ra = 83

T = 3369 K (464 nm + $Sr_{1,4}Ca_{0,6}Si_{0,95}Ge_{0,05}O_4:Eu^{2+}$) ; x = 0,4134, y = 0,3959, Ra = 74

T = 2787 K (466 nm + $Sr_{1,4}Ca_{0,6}Si_{0,98}P_{0,02}O_{4,01}:Eu^{2+}$) ; x = 0,4630, y = 0,4280, Ra = 72

T = 2913 K (464 nm + $Sr_{1,4}Ca_{0,6}Si_{0,98}Al_{0,02}O_4:Eu^{2+}$) ; x = 0,4425, y = 0,4050, Ra = 73

T= 4201 K

In einer bevorzugten Variante der Erfindung wird die Farbkonversion folgendermaßen durchgeführt:

Ein oder mehrere LED-Chips 1 (siehe Fig. 7) werden auf einer Leiterplatte 2 assembliert. Direkt über den LEDs wird (einerseits zum Schutz der LED-Chips und andererseits um das im LED-Chip erzeugte Licht besser auskoppeln zu können) ein Einkapselmittel 3 in der Form einer Halbkugel oder eines Halbellipsoids angeordnet. Dieses Verkapselmittel 3 kann entweder jeden Die einzeln umfassen, oder es kann eine gemeinsame Form für alle LEDs darstellen. Die derart bestückte Leiterplatte 2 wird in einen Reflektor 4 eingesetzt bzw. dieser wird über die LED-Chips 1 gestülpt.

Auf den Reflektor 4 wird eine Lichtscheibe 5 gesetzt. Diese dient einerseits dem Schutz der Anordnung, anderseits werden in diese Lichtscheibe die Luminophore 6 eingemischt. Das blaue Licht (oder die ultraviolette Strahlung), das durch die Lichtscheibe 5 hindurchtritt, wird beim Durchgang anteilig durch den Luminophor 6 in einen zweiten Spektralbereich konvertiert, so dass sich insgesamt ein weißer Farbeindruck ergibt. Verluste durch waveguiding-Effekte, wie diese bei planparallelen Platten auftreten, werden durch die opaken, streuenden Eigenschaften der Scheibe reduziert. Weiterhin sorgt der Reflektor 4 dafür, dass nur bereits vorgerichtetes Licht auf die Lichtscheibe 5 auftrifft, so dass Totalreflexionseffekte von vornherein reduziert werden.

Es ist auch möglich, den Luminophor 6 auf den Reflektor 4 aufzutragen, wie dies in Fig. 8 dargestellt ist. Es ist dann keine Lichtscheibe erforderlich.

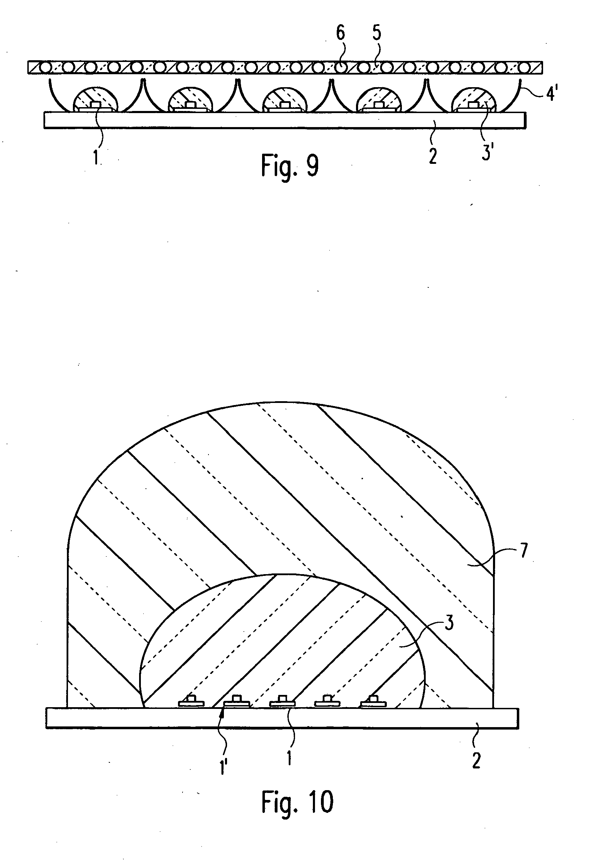

Alternativ dazu kann über jedem LED-Chip 1 (siehe Fig. 9) ein Reflektor 4' aufgesetzt sein und dieser kuppelförmig ausgegossen werden (Einkapselmittel 3') und eine Lichtscheibe 5 über jedem Reflektor 3' bzw. über der gesamten Anordnung angeordnet werden.

Für die Herstellung von Beleuchtungsquellen ist es zweckmäßig, anstelle von Einzel-LEDs LED-Arrays zu verwenden. In einer bevorzugten Variante der Erfindung wird die Farbkonversion auf einem LED-Array 1' (siehe Fig. 10), bei welchem die LED-Chips 1 direkt auf der Leiterplatte 2 assembliert werden, in folgender Form durchgeführt:

Ein LED-Array 1' (siehe Fig. 10) wird mittels einer Vergussmasse 3 (z.B. Epoxid) an eine transparente Polymerlinse 7, die aus einem anderen Material (z.B. PMMA) besteht, angeklebt. Das Material der Polymerlinse 7 und der Vergussmasse 3 werden derart ausgewählt, dass diese möglichst ähnliche Brechzahlen aufweisen - also phasenangepasst sind. Die Vergussmasse 3 befindet sich in einer maximal kugelförmigen oder ellipsoidförmigen Aushöhlung der Polymerlinse 7. Die Form der Aushöhlung ist insofern von Bedeutung, da in der Vergussmasse 3 das Farbkonversionsmaterial dispergiert ist, und daher durch die Formgebung sichergestellt werden kann, dass winkelunabhängige Emissionsfarben erzeugt werden. Alternativ dazu kann das Array zuerst mit einer transparenten Vergussmasse vergossen werden und anschließend mittels der Vergussmasse, die das Farbkonversionsmaterial beinhaltet, an die Polymerlinse geklebt werden.

Zur Herstellung weißer LEDs mit besonders guter Farbwiedergabe, bei denen zumindest zwei verschiedene Luminophore eingesetzt werden, ist es günstig, diese nicht gemeinsam in einer Matrix zu dispergieren, sondern diese getrennt zu dispergieren und aufzubringen. Dies gilt speziell für Kombinationen, bei denen die endgültige Lichtfarbe durch einen mehrstufigen Farbkonversionsprozess erzeugt wird. D.h., dass die langwelligste Emissionsfarbe durch einen Emissionsprozess generiert wird, der wie folgt abläuft: Absorption der LED-Emission durch den ersten Luminophor - Emission des ersten Luminophors - Absorption der Emission des ersten Luminophors durch den zweiten Luminophor und Emission des zweiten Luminophors. Speziell für einen derartigen Prozess ist es zu bevorzugen, die einzelnen Materialien in Lichtausbreitungsrichtung hintereinander anzuordnen, da damit die Konzentration der Materialien im Vergleich zu einer einheitlichen Dispersion der verschiedenen Materialien reduziert werden kann.

Die vorliegende Erfindung ist nicht auf die beschriebenen Beispiele eingeschränkt. Die Luminophore könnten auch in der Polymerlinse (oder einer anderen Optik) eingebracht sein. Es ist auch möglich, den Luminophor direkt über dem LED-Dice oder auf der Oberfläche der transparenten Vergussmasse anzuordnen. Auch kann der Luminophor zusammen mit Streupartikeln in eine Matrix eingebracht werden. Dadurch wird ein Absinken in der Matrix verhindert und ein gleichmäßiger Lichtaustritt gewährleistet.

**Patentansprüche**

1. Lichtquelle zur Erzeugung von weißem Licht mit wenigstens einem LED-Chip (1), der auf einer Leiterplatte (2) angeordnet ist, wobei der wenigstens eine LED-Chip (1) auf der Leiterplatte (2) innerhalb eines Reflektors (4) angeordnet ist, und wobei die Lichtquelle wenigstens zwei verschiedene Luminophore (6) aufweist, welche einzeln in Matrizen dispergiert sind und die in Lichtausbreitungs-Richtung hintereinander angeordnet sind, wobei ein erster Luminophor (6) auf dem Reflektor (4) aufgebracht ist, wobei eine Lichtscheibe (5) über dem Reflektor (4) angeordnet ist, wobei die Lichtscheibe (5) einen zweiten Luminophor (6) enthält, wobei der wenigstens eine LED-Chip (1) mit Einkapselmittel (3') vergossen ist, wobei die Lichtscheibe (5) beabstandet oberhalb des Einkapselmittels (3') angeordnet ist.

2. Lichtquelle nach Anspruch 1, wobei die Luminophore (6) in einer anorganischen Matrix aufgeschlämmt sind.

3. Lichtquelle nach Anspruch 1 oder 2, wobei das Einkapselmittel (3') kuppelartig, in der Form einer Halbkugel oder eines Halbellipsoids ausgebildet ist.

4. Lichtquelle nach Anspruch 1, 2 oder 3, bei der das Einkapselmittel (3') eine Vergussmasse (3) ist.

5. Lichtquelle nach Anspruch 4, wobei ein Luminophor (6) in der Vergussmasse (3) dispergiert ist.

6. Lichtquelle nach einem der vorhergehenden Ansprüche, wobei der wenigstens eine LED-Chip (1) blaues Licht und/oder UV-Strahlung erzeugt.

7. Verfahren zur Herstellung einer weißen LED Lichtquelle, aufweisend die Schritte:

    - Anordnen wenigstens eines LED Chips (1) innerhalb eines Reflektors (4) auf einer Leiterplatte (2),
    - Aufbringen von mindestens zwei verschiedenen Luminophoren (6) in Lichtausbreitungs-Richtung hintereinander, wobei die Luminophore einzeln in Matrizen dispergiert sind, wobei ein erster Luminophor auf dem Reflektor (4) aufgebracht ist und ein zweiter Luminophor in einer über dem Reflektor (4) angebrachten Lichtscheibe (5) enthalten ist, wobei der wenigstens eine LED Chip (1) mit Einkapselmittel (3') vergossen ist und die Lichtscheibe (5) beabstandet oberhalb des Einkapselmittels (3') angeordnet ist.

## Claims

1. Light source for generating white light comprising at least one LED chip (1), arranged on a printed circuit board (2), wherein the at least one LED chip (1) is arranged on the printed circuit board (2) within a reflector (4), and wherein the light source has at least two different luminophores (6) which are individually dispersed in matrices and which are arranged one behind another in the light propagation direction, wherein a first luminophore (6) is applied on the reflector (4), wherein a light plate (5) is arranged above the reflector (4), wherein the light plate (5) contains a second luminophore (6), wherein the at least one LED chip (1) is potted with encapsulation medium (3'), wherein the light plate (5) is arranged at a distance above the encapsulation medium (3').

2. Light source according to Claim 1, wherein the luminophores (6) are suspended in an inorganic matrix.

3. Light source according to Claim 1 or 2, wherein the encapsulation medium (3') is embodied in a dome-like manner, in the form of a hemisphere or a hemiellipsoid.

4. Light source according to Claim 1, 2 or 3, wherein the encapsulation medium (3') is a potting compound (3).

5. Light source according to Claim 4, wherein a luminophore (6) is dispersed in the potting compound (3).

6. Light source according to any of the preceding claims, wherein the at least one LED chip (1) generates blue light and/or UV radiation.

7. Method for producing a white LED light source, comprising the following steps:

- arranging at least one LED chip (1) within a reflector (4) on a printed circuit board (2),
- applying at least two different luminophores (6) one behind another in the light propagation direction, wherein the luminophores are individually dispersed in matrices, wherein a first luminophore is applied on the reflector (4) and a second luminophore is contained in a light plate (5) fitted above the reflector (4), wherein the at least one LED chip (1) is potted with encapsulation medium (3') and the light plate (5) is arranged at a distance above the encapsulation medium (3').

## Revendications

1. Source lumineuse destinée à produire de la lumière blanche avec au moins une puce à LED (1), qui est disposée sur un circuit imprimé (2), dans laquelle ladite au moins une puce à LED (1) est disposée sur le circuit imprimé (2) à l'intérieur d'un réflecteur (4), et dans laquelle la source lumineuse présente au moins deux luminophores (6) différents, qui sont dispersés individuellement dans des matrices et disposés l'un derrière l'autre dans la direction de propagation de la lumière, dans laquelle un premier luminophore (6) est monté sur le réflecteur (4), dans laquelle une plaque lumineuse (5) est disposée au-dessus du réflecteur (4), dans laquelle la plaque lumineuse (5) comprend un deuxième luminophore, dans laquelle ladite au moins une puce à LED (1) est scellée avec un moyen d'encapsulation (3'), dans laquelle la plaque lumineuse (5) est disposée à distance au-dessus du moyen d'encapsulation (3').

2. Source lumineuse selon la revendication 1, dans laquelle les luminophores (6) sont mis en suspension dans une matrice inorganique.

3. Source lumineuse selon la revendication 1 ou 2, dans laquelle le moyen d'encapsulation (3') est configuré de manière similaire à une coupole, de la forme d'un hémisphère ou d'un demi-ellipsoïde.

4. Source lumineuse selon la revendication 1, 2 ou 3, dans laquelle le moyen d'encapsulation (3') est une masse de scellement (3).

5. Source lumineuse selon la revendication 4, dans laquelle un luminophore (6) est dispersé dans la masse de scellement (3).

6. Source lumineuse selon l'une des revendications précédentes, dans laquelle ladite au moins une puce à LED (1) produit de la lumière bleue et/ou un rayonnement UV.

7. Procédé de fabrication d'une source lumineuse à LED blanche, présentant les étapes :

- disposer au moins une puce à LED (1) à l'intérieur d'un réflecteur (4) sur un circuit imprimé (2),

- monter au moins deux luminophores (6) différents l'un derrière l'autre dans la direction de propagation de la lumière, dans lequel les luminophores sont dispersés individuellement dans des matrices, dans lequel un premier luminophore (6) est monté sur le réflecteur (4) et un deuxième luminophore est compris dans une plaque lumineuse (5) fixée au-dessus du réflecteur (4), dans lequel ladite au moins une puce à LED (1) est scellée avec un moyen d'encapsulation (3') et la plaque lumineuse (5) est disposée à distance au-dessus du moyen d'encapsulation (3').

Fig. 1

Fig. 2

Fig. 3

Fig. 4

Fig. 5

Fig. 6

Fig. 7

Fig. 8

Fig. 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9805078 A
- WO 9812757 A
- WO 0033389 A
- WO 9750132 A

**In der Beschreibung aufgeführte Nicht-Patentliteratur**

- **VON S.H.M. POORT et al.** Optical properties of Eu2+-activated orthosilicates and orthophospates. *Journal of Alloys and Compounds,* 1997, vol. 260, 93-97